(19) Europäisches Patentamt European Patent Office Office européen des brevets

(11) **EP 2 403 119 B1**

(12) **FASCICULE DE BREVET EUROPEEN**

(45) Date de publication et mention
de la délivrance du brevet:
**18.07.2012 Bulletin 2012/29**

(51) Int Cl.:
***H02M 1/38*** *(2007.01)*     ***H03K 17/14*** *(2006.01)*

(21) Numéro de dépôt: **11169390.9**

(22) Date de dépôt: **10.06.2011**

(54) **Procédé de commande et système pour compenser les temps-morts dans une commande MLI**

Steuerungsverfahren und System zur Kompensation von Totzeiten für
Pulsweitenmodulationssteuerung

Control method and system for compensating for the dead-times in PWM control

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **29.06.2010 FR 1055194**

(43) Date de publication de la demande:
**04.01.2012 Bulletin 2012/01**

(73) Titulaire: **Schneider Toshiba Inverter Europe SAS
27120 Pacy sur Eure (FR)**

(72) Inventeurs:
• **Videt, Arnaud
59655 Villeneuve d'Ascq (FR)**

• **Arpilliere, Michel
75015 Paris (FR)**
• **Loizelet, Philippe
27120 Le Plessis Hebert (FR)**

(74) Mandataire: **Bié, Nicolas et al
Schneider Electric Industries SAS
Service Propriété Industrielle
35 rue Joseph Monier - CS 30323
92506 Rueil-Malmaison Cedex (FR)**

(56) Documents cités:
**EP-A1- 0 144 593   WO-A1-94/14233
US-A- 5 872 710**

EP 2 403 119 B1

**Description**

La présente invention se rapporte à un procédé et un système pour compenser les temps-morts dans une commande MLI (Modulation de largeur d'impulsion) d'un bras de commutation, le bras de commutation étant par exemple employé dans un onduleur à source de tension.

De manière connue, un onduleur, couramment employé dans un variateur de vitesse, comporte plusieurs bras de commutation reliés chacun à une charge électrique à commander. Les bras de commutation sont connectés en parallèle entre deux lignes d'alimentation connectées à une source de tension. Chaque bras comporte par exemple au moins deux interrupteurs connectés en série entre les deux lignes d'alimentation et un point milieu de connexion situé entre le premier interrupteur et le deuxième interrupteur et connecté à une charge électrique. Chaque interrupteur comporte notamment un transistor, par exemple de type IGBT associé à une diode.

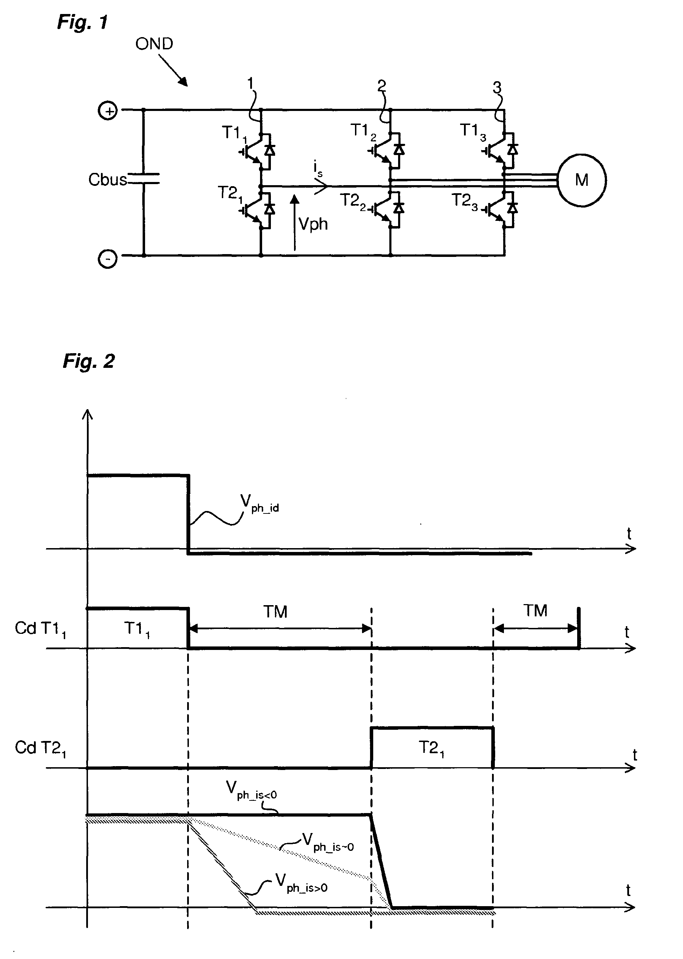

Dans un bras de commutation de l'onduleur représenté en figure 1, les deux interrupteurs sont commandés par des signaux MLI complémentaires (figure 2), c'est-à-dire que lorsque l'un des interrupteurs est à l'état fermé, l'autre interrupteur est à l'état ouvert et inversement. En outre, pour éviter que les deux interrupteurs se trouvent à l'état fermé en même temps, un temps-mort est inséré entre les temps de commutation à l'état fermé des deux interrupteurs. Pendant ce temps-mort, les deux interrupteurs sont donc à l'état ouvert. Ainsi on évite à coup sûr le court-circuit entre les deux lignes d'alimentation lorsque les deux interrupteurs sont à l'état fermé et les pointes de courant occasionnées par ce court-circuit.

Lors du temps-mort, la tension de sortie est déterminée par le signe du courant circulant dans le bras de commutation. Par exemple un courant positif (allant en direction de la charge) génère une tension de sortie négative et un courant négatif (allant de la charge vers les interrupteurs) génère une tension de sortie positive. Cette situation engendre une grande indétermination sur la tension de sortie réellement appliquée lors du temps-mort. La figure 2 montre schématiquement l'évolution de la tension de sortie selon le signe du courant.

Pour maîtriser cette situation, il est connu d'appliquer une compensation tenant compte du temps-mort.

Dans l'état de la technique, plusieurs méthodes ont été employées pour réaliser cette compensation.

L'une de ces méthodes, décrite par exemple dans les demandes de brevet US2009/278621 ou US 7,286,375, consiste à regarder le signe du courant en sortie du bras de commutation et à adapter la durée des impulsions de commutation en fonction de ce signe. Cette estimation est néanmoins imprécise dès lors que ce courant s'approche de zéro, car elle ne rend pas compte de la pente de la commutation, qui peut devenir très lente, et encore moins des commutations non linéaires qui se produisent lorsque la montée en tension n'est toujours pas terminée après le temps-mort, par exemple au moment de la mise en conduction de l'interrupteur $T2_1$ (courbe $vp_{h-is-0}$, figure 2).

Une autre méthode connue consiste à employer des comparateurs rapides pour détecter le moment où la tension passe à la moitié de sa variation attendue (c'est-à-dire à la tension du bus divisée par deux sur un onduleur classique). Cette méthode est plus performante que la précédente mais pas optimale car elle ne permet pas de tenir compte des commutations non linéaires alors que celles-ci sont fréquentes lorsque l'onduleur délivre une tension de faibles fréquence et amplitude, par exemple pour commander une charge à basse vitesse.

Une autre méthode connue, décrite dans le brevet US 5,450,306, consiste à intégrer la tension de la charge sur une période de découpage et à transmettre cette information au microcontrôleur en vue d'une compensation ultérieure. Dans cette solution, l'intégration est réalisée de manière numérique, ce qui la rend particulièrement coûteuse et nécessite une horloge à haute fréquence pour capter précisément le temps-mort.

Une autre méthode connue, décrite dans le brevet EP 0144593, consiste à intégrer la tension de sortie durant une fenêtre de temps large arrivant à une correction lente.

Le but de l'invention est de proposer un procédé de commande permettant de compenser les temps-morts dans une commande de type MLI, le procédé étant fiable, facile à mettre en oeuvre et permettant de pallier les inconvénients des méthodes antérieures présentées ci-dessus.

Ce but est atteint par un procédé pour compenser les temps-morts dans une commande de type MLI appliquée à un bras de commutation connecté entre deux lignes d'alimentation, le bras de commutation comportant un premier interrupteur, un deuxième interrupteur et un point milieu de connexion situé entre le premier interrupteur et le deuxième interrupteur et connecté à une charge électrique, ladite commande MLI consistant, pour une impulsion, à effectuer une commutation du premier interrupteur et une commutation du deuxième interrupteur et à insérer un temps-mort entre la commutation du premier interrupteur et la commutation du deuxième interrupteur en vue d'appliquer une tension de sortie à la charge, le procédé étant caractérisé en ce qu'il comporte des étapes de :

-    intégration de la tension de sortie durant une fenêtre de temps déterminée incluant le temps-mort afin de déterminer une durée de compensation,
-    application de la durée de compensation pour corriger la largeur de l'impulsion courante ou celle d'une impulsion suivante.

Selon une particularité, la fenêtre de temps est définie pour inclure un seul temps-mort.

Selon une particularité, l'intégration est réalisée à l'aide d'un intégrateur analogique comportant un condensateur.

Selon une autre particularité, la durée de compensation est déterminée grâce à un instant détecté lors d'une charge/décharge du condensateur.

Selon une autre particularité, le début de la fenêtre de temps est synchronisé avec un ordre d'ouverture de l'un des interrupteurs.

L'invention concerne également un système pour compenser les temps-morts dans une commande de type MLI appliquée à un bras de commutation connecté entre deux lignes d'alimentation, le bras de commutation comportant un premier interrupteur, un deuxième interrupteur et un point milieu de connexion situé entre le premier interrupteur et le deuxième interrupteur et connecté à une charge électrique, ladite commande MLI consistant, pour une impulsion, à effectuer une commutation du premier interrupteur et une commutation du deuxième interrupteur et à insérer un temps-mort entre la commutation du premier interrupteur et la commutation du deuxième interrupteur en vue d'appliquer une tension de sortie à la charge, le système étant caractérisé en ce qu'il comporte :

- un intégrateur analogique destiné à l'intégration de la tension de sortie durant une fenêtre de temps déterminée incluant le temps-mort afin de déterminer une durée de compensation,
- des moyens de commande pour corriger la largeur de l'impulsion courante ou celle d'une impulsion suivante en appliquant la durée de compensation déterminée.

Selon une particularité, le début de la fenêtre de temps est synchronisé avec un ordre d'ouverture de l'un des interrupteurs.

Selon une autre particularité, l'intégrateur analogique comporte un condensateur.

Selon une autre particularité, la durée de compensation est déterminée grâce à un instant de fin de cycle détecté lors d'une charge/décharge du condensateur.

Selon une autre particularité, le système comporte des moyens de commande de l'intégrateur analogique destinés à activer la charge ou la décharge du condensateur de l'intégrateur et des moyens de détection de l'instant de fin de cycle auquel la tension aux bornes du condensateur revient à sa valeur de repos après la fenêtre de temps.

D'autres caractéristiques et avantages vont apparaître dans la description détaillée qui suit en se référant à un mode de réalisation donné à titre d'exemple et représenté par les dessins annexés sur lesquels :

- la figure 1 représente un onduleur connecté à une charge électrique,

- la figure 2 représente de manière schématique l'évolution de la tension de sortie lors d'une commutation sur un bras de commutation,

- la figure 3 représente schématiquement l'architecture du système de l'invention,

- la figure 4 illustre de manière simplifiée le principe de fonctionnement de l'invention,

- la figure 5 représente un dispositif électronique employé dans le système de l'invention et fonctionnant selon le principe de fonctionnement représenté sur la figure 4,

- la figure 6 représente la simulation obtenue grâce au dispositif illustré sur la figure 5.

L'invention s'applique à la compensation des temps-morts dans une commande MLI appliquée à un bras de commutation. Le bras de commutation pourra être employé dans un redresseur actif ou un onduleur à source de tension.

Par onduleur à source de tension, on entend tous les onduleurs classiques à deux niveaux ou plus qui comportent un bus continu d'alimentation, de même que les onduleurs dits à condensateur flottant ("flying capacitor") et les onduleurs de type convertisseur matriciel ("matrix converter"). Dans la suite de la description on s'intéresse à un onduleur classique à deux niveaux mais il faut comprendre que l'invention s'applique à tous les onduleurs évoqués ci-dessus.

De manière connue, un onduleur OND classique tel que représenté sur la figure 1 et par exemple employé dans un variateur de vitesse comporte deux lignes d'alimentation, une ligne d'alimentation positive et une ligne d'alimentation négative, entre lesquelles sont connectés un condensateur de bus Cbus et plusieurs bras de commutation 1, 2, 3. Typiquement, chaque bras de commutation 1, 2, 3 comporte au moins deux interrupteurs de commutation ($T1_1$, $T2_1$, $T1_2$, $T2_2$, $T1_3$, $T2_3$) connectés entre les deux lignes d'alimentation. Sur chaque bras, un point milieu de connexion situé entre les deux interrupteurs est connecté à la charge électrique M.

Le procédé de l'invention peut s'appliquer sur chaque bras de commutation de l'onduleur indépendamment.

Dans la suite de la description, on raisonnera donc sur un seul bras de commutation 1 qui comporte par exemple les transistors $T1_1$ et $T2_1$.

En référence à la figure 2, une impulsion d'une commande MLI réalisée par des moyens de commande comporte par exemple dans l'ordre chronologique :

- le maintien à l'état fermé de l'interrupteur $T1_1$ pendant une certaine durée (courbe Cd $T1_1$),

- un ordre d'ouverture de l'interrupteur $T1_1$ (courbe Cd $T1_1$),

- un temps-mort TM pendant lequel les deux transistors $T1_1$, $T2_1$ sont à l'état ouvert,

- un ordre dé fermeture de l'interrupteur $T2_1$ (courbe Cd $T2_1$),

- le maintien à l'état fermé de l'interrupteur $T2_1$ pendant une certaine durée (courbe Cd $T2_1$),

- un ordre d'ouverture de l'interrupteur $T2_1$ (courbe Cd $T2_1$),

- un nouveau temps-mort,

- un ordre de fermeture de l'interrupteur $T1_1$ (courbe Cd $T1_1$).

Les durées de commutation des interrupteurs sont déterminées selon la tension de sortie $V_{Ph}$ que l'on souhaite appliquer à la charge électrique M. En dehors du temps-mort TM, la tension de sortie $Vp_h$ est maîtrisée car l'un des interrupteurs est toujours à l'état fermé. En revanche durant le temps-mort TM, qui est nécessaire pour éviter de court-circuiter le bus continu, l'évolution de la tension dépend du signe et de la valeur du courant $i_s$. La figure 2 illustre cet aspect. Sur cette figure 2, on peut voir que la tension de sortie $Vp_h$ obtenue réellement en sortie du bras de commutation présente un profil différent selon que le courant est positif ($Vp_{h\_is>0}$), négatif ($V_{ph-is<0}$) ou proche de zéro ($V_{ph\_is\sim0}$). Cette figure 2 montre également la tension idéale $V_{ph\_id}$ que l'on souhaite obtenir.

L'invention consiste ainsi à connaître précisément l'évolution de la tension pendant le temps-mort TM afin de pouvoir réaliser une compensation de l'erreur générée par l'application obligatoire du temps-mort TM.

Le but de l'invention est ainsi de compenser les incertitudes sur.la tension de sortie appliquée à une charge électrique M occasionnées par la présence obligatoire d'un temps-mort entre la commutation d'un premier interrupteur et la commutation d'un deuxième interrupteur commandé par MLI.

Pour cela, l'invention propose un procédé permettant de réaliser une intégration de la tension de sortie ($V_{ph}$) sur une fenêtre d'intégration Wint incluant le temps-mort TM. Ainsi, le procédé permet de déterminer les volts-secondes appliqués en sortie du bras de commutation sur la fenêtre d'intégration.

La fenêtre d'intégration Wint est définie pour comporter un seul temps-mort TM. Une intégration différente est donc réalisée pour chaque temps-mort appliqué dans la commande MLI. Une nouvelle fenêtre d'intégration Wint débute pour chaque nouveau temps-mort TM et se termine juste après la fin du temps-mort.

Le début de la fenêtre d'intégration Wint est synchronisé avec l'ordre logique d'ouverture de l'un des interrupteurs du bras de commutation. La fenêtre d'intégration peut débuter avant l'ordre d'ouverture de l'un des interrupteurs mais ce cas nécessite de connaître le décalage existant entre le début de la fenêtre et l'ordre logique d'ouverture de l'interrupteur. La fenêtre d'intégration Wint se termine juste après la fin du temps-mort afin de pouvoir tenir compte des éventuels délais de propagation et des temps de commutation des interrupteurs. La durée de la fenêtre d'intégration Wint peut être toujours fixe et préenregistrée dans la commande si la durée du temps-mort TM est toujours identique ou elle peut par exemple s'adapter à la durée du temps-mort en étant désactivée systématiquement après une durée déterminée suivant la fin du temps-mort (par exemple $1\mu s$).

En mesurant l'intégrale de la tension de sortie $V_{ph}$ sur la durée de la fenêtre d'intégration Wint, cela permet de maximiser la précision de la mesure là où la tension est la plus incertaine. En effet, comme rappelé ci-dessus, en dehors du temps-mort TM, la tension de sortie $V_{ph}$ est maîtrisée et sa mesure n'est donc pas critique. Idéalement, l'intégration est réalisée pour chaque temps-mort.

Selon l'invention, le principe retenu consiste donc à :

- Définir une fenêtre d'intégration Wint incluant le temps-mort TM, ladite fenêtre ayant une durée légèrement plus importante que celle du temps-mort (par exemple temps-mort+$1\mu s$).

- Intégrer la tension de sortie mesurée durant cette fenêtre d'intégration en vue d'en déduire une durée de compensation.

- Une fois la durée de la fenêtre écoulée, appliquer la durée de compensation déterminée sur la largeur de l'impulsion courante ou sur celle d'une impulsion suivante.

Selon l'invention, pour réaliser l'intégration, on utilise un intégrateur (INT) analogique basé sur la charge d'un condensateur par un courant proportionnel à la tension à intégrer. Une fois la fenêtre d'intégration passée, la tension accumulée aux bornes du condensateur est restituée sous la forme d'un temps proportionnel à la variation de tension occasionnée durant la phase d'intégration. L'instant auquel la tension aux bornes du condensateur revient à sa valeur initiale est détecté et traité pour déterminer la durée de compensation.

La décharge du condensateur est par exemple réalisée à l'aide d'une source de courant qui peut être :

- Constante, c'est-à-dire définie par les caractéristiques des composants employés. Dans ce cas, lors de la décharge du condensateur, on récupère réellement des volts-secondes qu'il faudra ensuite normaliser par la tension du bus continu afin de corriger la largeur de l'impulsion pour effectuer une compensation.
- Dépendante, c'est-à-dire proportionnelle, à la tension du bus continu en entrée de l'onduleur. Dans ce cas, l'intégrale mesurée est déjà normalisée par la tension du bus continu et correspond à un temps directement exploitable pour réaliser la compensation.

En variante de réalisation, l'intégration peut être réalisée lors de la décharge du condensateur, la source de courant effectuant la charge du condensateur.

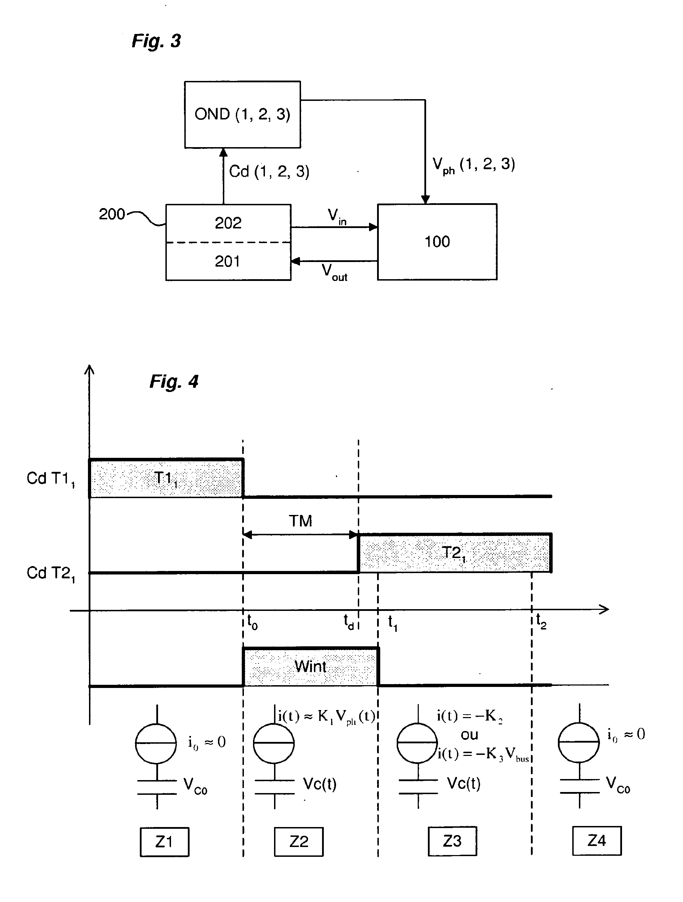

La figure 4 illustre le principe de fonctionnement de l'invention. L'invention consiste en effet à se ramener à un condensateur chargé par une source de courant dont la valeur dépend de l'état du système.

En zone 1 (Z1), c'est-à-dire jusqu'à l'instant $t_0$ (correspondant à un ordre d'ouverture), l'interrupteur $T1_1$ est maintenu à l'état fermé, la tension aux bornes du condensateur est fixe et vaut une tension de repos désignée $V_{c0}$. Aucun courant ne circule dans le condensateur.

A $t_0$, un ordre d'ouverture est envoyé à $T1_1$. Le début de la fenêtre d'intégration Wint est synchronisé avec l'envoi de cet ordre.

La zone 2 (Z2) dure entre $t_0$ et $t_1$ et correspond à la fenêtre d'intégration Wint, cette fenêtre se terminant après la fin du temps-mort TM. Pendant la fenêtre d'intégration Wint, la tension $V_c(t)$ aux bornes du condensateur évolue en fonction du courant i(t) selon la relation suivante :

$i(t) = K_1 V_{Ph}(t)$ dans laquelle $V_{ph}(t)$ correspond à la tension de sortie et $K_1$ est un coefficient constant.

A $t_1$, la tension $V_c$ aux bornes du condensateur s'exprime donc par la relation suivante :

$$V_C(t_1) = V_{C0} + \frac{K_1}{C} \int_{t_0}^{t_1} V_{ph}(t) dt \qquad (1)$$

Dans laquelle C correspond à la capacité du condensateur.

Lorsque la fenêtre d'intégration Wint est terminée, c'est-à-dire à l'instant $t_1$, la source de courant du schéma équivalent change de sens, forçant une évolution de $V_c(t)$ en sens contraire de celui de l'évolution de $V_c(t)$ durant l'intégration. $V_c(t)$ se rapproche donc progressivement de la tension de repos $V_{c0}$ et l'atteint à l'instant $t_2$.

Si la source de courant est constante suivant la relation $i(t) = -K_2$, l'évolution de la tension $V_c(t)$ suit la relation suivante :

$$V_C(t) = V_C(t_1) - \frac{K_2}{C}(t - t_1)$$

Avec $V_c(t_2) = V_{c0}$ et à partir de la relation (1) ci-dessus, on obtient alors :

$$t_2 - t_1 = \frac{K_1}{K_2} \int_{t_0}^{t_1} V_{ph}(t) dt$$

Si la source de courant est dépendante de la tension du bus continu selon la relation i(t) = -K$_3$ V$_{bus}$ , on obtient sur la zone 3 (Z3) :

$$V_C(t) = V_C(tl) - \frac{K_3}{C} \int_{t_1}^{t} V_{bus}(u)du$$

Soit la relation suivante $V_C(t) \approx V_C(t_1) - \frac{K_3 V_{bus}}{C}(t - t_1)$ dans laquelle la tension V$_{bus}$ est supposée constante entre t$_1$ et t$_2$ et égale à sa valeur en t$_1$. On obtient alors :

$$t_2 - t_1 = \frac{K_1}{K_3} \int_{t_0}^{t_1} \frac{V_{ph}(t)}{V_{bus}}dt$$

Après t$_2$, le système est revenu à son état stable et est prêt à fonctionner pour une nouvelle commutation (Z4).

L'invention consiste donc à détecter l'instant t$_2$ de fin de cycle ou autrement dit de retour à la tension initiale (V$_{c0}$) pour le condensateur, cet instant étant ensuite employé pour calculer une durée de compensation à appliquer dans la commande MLI pour corriger la largeur de l'impulsion courante ou celle d'une impulsion suivante. La durée de compensation pourra s'exprimer par exemple par la relation t$_2$-t$_1$ ou la relation t$_2$-t$_0$, l'instant t$_2$ détecté devant être associé à un instant connu et mémorisé par la commande tel que par exemple t$_0$, t$_1$ ou même t$_2$ d'une commutation précédente.

Selon l'invention, en référence à la figure 3 le système permettant de mettre en oeuvre ledit procédé pour la commande de l'onduleur OND comporte donc notamment un dispositif électronique 100 permettant de réaliser l'intégration selon les principes définis ci-dessus et des moyens de commande 200 comportant des moyens de calcul 201 permettant de déterminer les compensations et des moyens 202 pour générer la commande MLI des bras de commutation (Cd (1, 2, 3)) en tenant compte pour chaque bras des compensations calculées. Sur la figure 3, les tensions de sortie V$_{ph}$ pour chacun des bras de commutation 1, 2, 3 sont envoyées au dispositif électronique 100 pour intégration. En fonction des signaux de tension V$_{in}$ envoyés par les moyens 202 pour amorcer la fenêtre d'intégration Wint, les moyens de calcul 201 récupèrent les signaux de tension V$_{out}$ permettant de détecter pour chaque bras les instants employés pour calculer les durées de compensation.

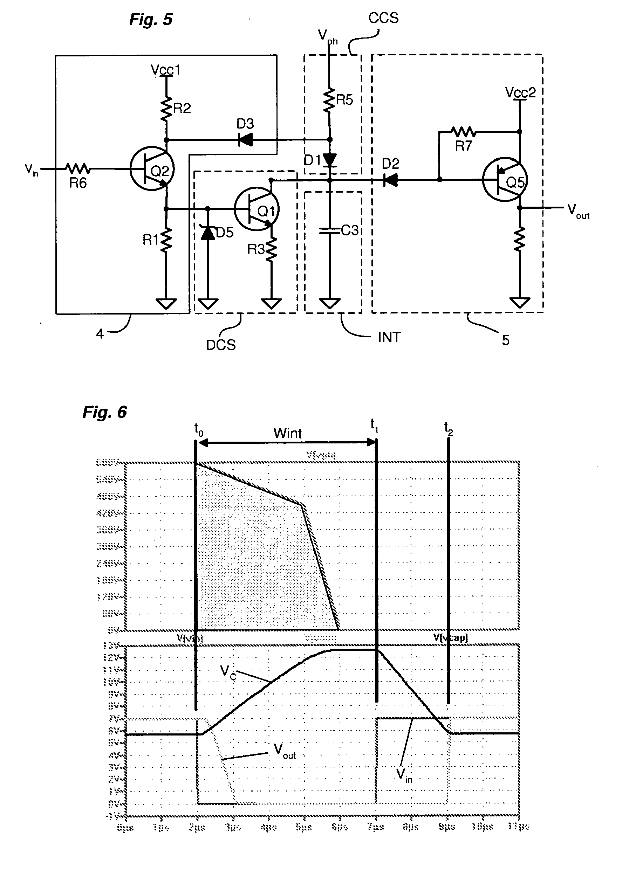

La figure 5 montre un exemple de réalisation d'un dispositif électronique permettant de réaliser l'intégration de la tension de sortie V$_{ph}$ au cours de la fenêtre d'intégration (Wint) et de détecter l'instant t$_2$ défini ci-dessus. Le dispositif montré sur cette figure 5 fonctionne selon le principe décrit ci-dessus en liaison avec la figure 4.

Dans cette réalisation, le dispositif comporte un intégrateur analogique (INT) comportant un condensateur (C3), des moyens de commande 4 de l'intégrateur analogique destinés à activer la charge ou la décharge du condensateur de l'intégrateur (INT) et des moyens de détection 5 de l'instant t$_2$ de fin de cycle auquel la tension aux bornes du condensateur revient à sa valeur de repos après la fenêtre d'intégration (Wint).

Plus précisément sur la figure 5, le dispositif comporte deux sources de courant distinctes CCS, DCS de manière à reproduire le fonctionnement illustré par les zones Z2 et Z3 de la figure 4.

La première source de courant CCS est une simple résistance R5 et est employée comme source de courant destinée à la charge du condensateur C3. La seconde source de courant DCS est une source "active" destinée à la décharge du condensateur C3 et est composée de l'association d'un transistor Q1, d'une diode zener D5 et d'une résistance R3. Dans cette réalisation, les deux sources sont connectées en permanence au condensateur C3 et des moyens de commande 4 permettent d'assurer la commutation entre l'une et l'autre, de manière à se retrouver dans la situation illustrée par la zone Z2 ou la zone Z3 sur la figure 4. Ce pilotage est réalisé à l'aide d'un transistor Q2 commandé par un signal de commande V$_{in}$. L'ouverture du transistor Q2 qui permet de démarrer la fenêtre d'intégration Wint est synchronisée avec un ordre d'ouverture de chaque interrupteur du bras de commutation, cet ordre de commutation marquant systématiquement le début d'un temps-mort. L'ordre de fermeture du transistor Q2 correspond à la fin de la fenêtre d'intégration. Les moyens de détection 5 permettent de détecter l'instant t$_2$ défini ci-dessus.

Ainsi lorsque le signal V$_{in}$ est à 0V, le transistor Q2 est ouvert. La première source de courant CCS fonctionne tandis que l'autre source de courant DCS est désactivée. Le condensateur C3 de l'intégrateur se charge donc à travers la résistance R5 et la diode D1.

Lorsque le signal $V_{in}$ est au potentiel Vcc2 (=7V), le transistor Q2 devient passant et le courant issu de Vph passe par le transistor Q2, la diode D1 se trouvant alors bloquée. Vu du condensateur C3, la première source CCS est désactivée. Dans le même temps, la tension aux bornes de la diode zener D5 apparaît sur la base du transistor Q1 dans la deuxième source de courant DCS. La deuxième source de courant DCS est alors en fonctionnement et décharge le condensateur C3. Le signal de commande $V_{in}$ permet donc de commuter les sources de courant et ce schéma constitue un mode de réalisation du principe général présenté en figure 3, sur les zones Z2 et Z3.

Quand la tension aux bornes du condensateur C3 diminue sous l'influence de la seconde source de courant DCS jusqu'à devenir légèrement inférieure à Vcc2, le transistor Q5 passe en conduction et la tension $V_{out}$ commute de la tension égale à 0V à la tension Vcc2, correspondant à l'instant $t_2$ à détecter.

Ensuite, la seconde source DCS est toujours en fonctionnement mais tout son courant passe par Vcc2 et les moyens de détection 5. Il n'y a donc plus de courant circulant dans le condensateur C3. C'est donc l'état stable correspondant aux zones Z1 et Z4 de la figure 4, pendant lequel, vu du condensateur C3, toutes les sources de courant sont désactivées.

Lorsque le signal de commande $V_{in}$ revient à 0V à nouveau (à l'occasion d'une nouvelle commutation), la seconde source DCS est réellement désactivée et la première source de courant CCS charge le condensateur C3 au-dessus de la tension Vcc2, entraînant le blocage de la diode D2 ainsi que du transistor Q5. La tension $V_{out}$ retombe alors à 0V durant cette phase.

Pour résumer, la séquence de fonctionnement de ce dispositif est donc la suivante :

**Etat stable initial** (l'un des interrupteurs du bras de commutation est à l'état fermé) :

- $V_{in}$=+7V - le transistor Q2 est fermé, de même que le transistor Q1, la tension $V_{out}$ est alors à +7V.

- Le condensateur C3 est déchargé.

**Début de la fenêtre d'intégration** (=ordre d'ouverture de l'un des interrupteurs T1, ou $T2_1$).

- $V_{in}$=0V. - Les transistors Q1 et Q2 sont ouverts.

- Le condensateur C3 se charge via la résistance R5, en vue d'intégrer la tension de sortie $V_{ph.}$

- Le transistor Q5 devient bloqué, ainsi la tension $V_{out}$ descend à 0V.

**Fin de la fenêtre d'intégration** (=juste après la fin du temps-mort).

- $V_{in}$=+7V - le transistor Q2 est fermé, ce qui entraîne la mise en conduction de la diode D3 et le blocage de la diode D1,

- La diode zener D5 devient passante entraînant la fermeture du transistor Q1 qui laisse passer le courant dans la résistance R3.

- Le condensateur C3 se décharge alors linéairement.

- Le transistor Q5 devient passant lorsque la tension aux bornes du condensateur C3 passe légèrement au-dessous de 7V. La tension $V_{out}$ augmente alors jusqu'à 7V. Le moment où la tension $V_{out}$ a atteint 7V est détecté et traité ultérieurement pour déterminer une durée de compensation du temps-mort. La durée de compensation déterminée est ensuite employée par la commande MLI du bras de commutation.

**Commutation suivante**

- Retour à l'état initial.

La figure 6 présente les courbes de simulation correspondant au dispositif de la figure 5. Sur ces courbes, on peut notamment voir que l'instant $t_2$ à détecter correspond à l'instant où la tension aux bornes du condensateur C3 revient à sa valeur de repos (qui n'est pas forcément nulle). De même cette simulation montre en grisé, durant la fenêtre d'intégration Wint, la surface à intégrer délimitée par la courbe de la tension de sortie $V_{ph}$.

Des variantes de réalisation ou des perfectionnements à ce dispositif peuvent être envisagés pour mettre en oeuvre le principe de fonctionnement illustré par la figure 4. Voici, de manière non exhaustive, quelques éléments de modifications possibles :

- employer un commutateur électronique directement entre les sources de courant et le condensateur,

- employer une seule source de courant pouvant prendre différentes valeurs,

- employer des sources de courant de différentes topologies. Elles peuvent être réalisées par un simple circuit RC, par un circuit actif (comme la seconde source DCS de la figure 5), par des miroirs de courant ou bien par tout autre moyen,

- la valeur de la source de courant peut être dépendante d'un signal extérieur, tel que par exemple la tension du bus de l'onduleur, comme décrit ci-dessus,

- le condensateur C3 peut avoir l'une de ses bornes à un potentiel fixe, mais pas nécessairement,

- la tension du condensateur C3 peut augmenter durant la zone Z3 et baisser durant la zone Z4, mais l'inverse est aussi possible.

**Revendications**

1. Procédé pour compenser les temps-morts (TM) dans une commande de type MLI appliquée à un bras de commutation (1) connecté entre deux lignes d'alimentation, le bras de commutation comportant un premier interrupteur ($T1_1$), un deuxième interrupteur ($T2_1$) et un point milieu de connexion situé entre le premier interrupteur et le deuxième interrupteur et connecté à une charge électrique (M), ladite commande MLI consistant, pour une impulsion, à effectuer une commutation du premier interrupteur ($T1_1$) et une commutation du deuxième interrupteur ($T2_1$) et à insérer un temps-mort entre la commutation du premier interrupteur et la commutation du deuxième interrupteur en vue d'appliquer une tension de sortie ($V_{ph}$) à la charge (M), le procédé étant **caractérisé en ce qu'**il comporte des étapes de :

   - intégration de la tension de sortie ($V_{ph}$) durant une fenêtre de temps (Wint) déterminée incluant un seul temps-mort (TM) afin de déterminer une durée de compensation,
   - application de la durée de compensation pour corriger la largeur de l'impulsion courante ou celle d'une impulsion suivante.

2. Procédé selon la revendication 1, **caractérisé en ce que** l'intégration est réalisée à l'aide d'un intégrateur analogique (INT).

3. Procédé selon la revendication 2, **caractérisé en ce que** l'intégrateur analogique (INT) comporte un condensateur (C3).

4. Procédé selon la revendication 3, **caractérisé en ce que** la durée de compensation est déterminée grâce à un instant ($t_2$) détecté lors d'une charge/décharge du condensateur (C3).

5. Procédé selon l'une des revendications précédentes, **caractérisé en ce que** le début de la fenêtre de temps (Wint) est synchronisé avec un ordre d'ouverture de l'un des interrupteurs.

6. Système pour compenser les temps-morts (TM) dans une commande de type MLI appliquée à un bras de commutation (1) connecté entre deux lignes d'alimentation, le bras de commutation comportant un premier interrupteur ($T1_1$), un deuxième interrupteur ($T2_1$) et un point milieu de connexion situé entre le premier interrupteur et le deuxième interrupteur et connecté à une charge électrique (M), ladite commande MLI consistant, pour une impulsion, à effectuer une commutation du premier interrupteur et une commutation du deuxième interrupteur et à insérer un temps-mort (TM) entre la commutation du premier interrupteur et la commutation du deuxième interrupteur en vue d'appliquer une tension de sortie ($V_{ph}$) à la charge, le système étant **caractérisé en ce qu'**il comporte :

   - un intégrateur analogique (INT) destiné à l'intégration de la tension de sortie ($V_{ph}$) durant une fenêtre de temps (Wint) déterminée incluant un seul temps-mort (TM) afin de déterminer une durée de compensation,
   - des moyens de commande (200) pour corriger la largeur de l'impulsion courante ou celle d'une impulsion suivante en appliquant la durée de compensation déterminée.

7. Système selon la revendication 6, **caractérisé en ce que** le début de la fenêtre de temps (Wint) est synchronisé avec un ordre d'ouverture de l'un des interrupteurs.

8. Système selon la revendication 6 ou 7, **caractérisé en ce que** l'intégrateur analogique (INT) comporte un condensateur.

9. Système selon la revendication 8, **caractérisé en ce que** la durée de compensation est déterminée grâce à un instant de fin de cycle ($t_2$) détecté lors d'une charge/décharge du condensateur (C3).

10. Système selon la revendication 9, **caractérisé en ce qu'**il comporte des moyens de commande (4) de l'intégrateur analogique (INT) destinés à activer la charge ou la décharge du condensateur (C3) de l'intégrateur (INT) et des moyens de détection (5) de l'instant ($t_2$) de fin de cycle auquel la tension aux bornes du condensateur (C3) revient à sa valeur de repos après la fenêtre de temps (Wint).

**Claims**

1. Method for compensating for the dead-times (TM) in PWM-type control applied to a switching arm (1) connected between two power supply lines, the switching arm comprising a first switch ($T1_1$), a second switch ($T2_1$) and a connection midpoint situated between the first switch and the second switch and connected to an electrical load (M), the said PWM control consisting, for a pulse, in performing a switching of the first switch ($T1_1$) and a switching of the second switch ($T2_1$) and in inserting a dead-time between the switching of the first switch and the switching of the second switch with a view to applying an output voltage ($V_{ph}$) to the load (M), the method being **characterized in that** it comprises steps of:

   - integrating the output voltage ($V_{ph}$) during a determined time window (Wint) including a single dead-time (TM) so as to determine a duration of compensation,
   - applying the duration of compensation so as to correct the width of the current pulse or that of a following pulse.

2. Method according to Claim 1, **characterized in that** the integration is carried out with the aid of an analogue integrator (INT).

3. Method according to Claim 2, **characterized in that** the analogue integrator (INT) comprises a capacitor (C3).

4. Method according to Claim 3, **characterized in that** the duration of compensation is determined by virtue of an instant ($t_2$) detected during a charging/discharging of the capacitor (C3).

5. Method according to one of the preceding claims, **characterized in that** the start of the time window (Wint) is synchronized with an order to open one of the switches.

6. System for compensating for the dead-times (TM) in PWM-type control applied to a switching arm (1) connected between two power supply lines, the switching arm comprising a first switch ($T1_1$), a second switch ($T2_1$) and a connection midpoint situated between the first switch and the second switch and connected to an electrical load (M), the said PWM control consisting, for a pulse, in performing a switching of the first switch and a switching of the second switch and in inserting a dead-time (TM) between the switching of the first switch and the switching of the second switch with a view to applying an output voltage ($V_{ph}$) to the load, the system being **characterized in that** it comprises:

   - an analogue integrator (INT) intended for integrating the output voltage ($V_{ph}$) during a determined time window (Wint) including a single dead-time (TM) so as to determine a duration of compensation,
   - control means (200) for correcting the width of the current pulse or that of a following pulse by applying the duration of compensation determined.

7. System according to Claim 6, **characterized in that** the start of the time window (Wint) is synchronized with an order to open one of the switches.

8. System according to Claim 6 or 7, **characterized in that** the analogue integrator (INT) comprises a capacitor.

9. System according to Claim 8, **characterized in that** the duration of compensation is determined by virtue of an end-of-cycle instant ($t_2$) detected during a charging/discharging of the capacitor (C3).

10. System according to Claim 9, **characterized in that** it comprises control means (4) for the analogue integrator (INT) intended to activate the charging or the discharging of the capacitor (C3) of the integrator (INT) and means (5) for detecting the end-of-cycle instant ($t_2$) at which the voltage across the terminals of the capacitor (C3) returns to its quiescent value after the time window (Wint).

**Patentansprüche**

1. Verfahren zum Kompensieren der Totzeiten (TM) in einer Steuerung der Art IBM (Impulsbreitenmodulation), die an einen Schaltarm (1) angewendet wird, der zwischen zwei Speiseleitungen verbunden ist, wobei der Schaltarm einen ersten Schalter ($T1_1$), einen zweiten Schalter ($T2_1$) und einen Schaltmittelpunkt aufweist, der sich zwischen dem ersten Schalter und dem zweiten Schalter befindet und mit einer elektrischen Last (M) verbunden ist, wobei die IBM-Steuerung für einen Impuls darin besteht, eine Umschaltung des ersten Schalters ($T1_1$) und eine Umschaltung des zweiten Schalters ($T2_1$) durchzuführen und eine Totzeit zwischen die Umschaltung des ersten Schalters und die Umschaltung des zweiten Schalters einzufügen, um eine Ausgangsspannung ($V_{ph}$) an die Last (M) anzulegen, wobei das Verfahren **dadurch gekennzeichnet ist, dass** es die folgenden Schritte aufweist:

   - Integration der Ausgangsspannung (Vph) während eines bestimmten Zeitfensters (Wint), das nur eine Totzeit (TM) enthält, um eine Kompensationsdauer zu bestimmen,
   - Anlegen der Kompensationsdauer, um die Breite des laufenden Impulses oder diejenige eines folgenden Impulses zu korrigieren.

2. Verfahren nach Anspruch 1, **dadurch gekennzeichnet, dass** die Integration mit Hilfe eines analogen Integrators (INT) durchgeführt wird.

3. Verfahren nach Anspruch 2, **dadurch gekennzeichnet, dass** der analoge Integrator (INT) einen Kondensator (C3) aufweist.

4. Verfahren nach Anspruch 3, **dadurch gekennzeichnet, dass** die Kompensationsdauer mit Hilfe eines Augenblicks ($t_2$) bestimmt wird, der bei einer Ladung/Entladung des Kondensators (C3) erfasst wird.

5. Verfahren nach einem der vorhergehenden Ansprüche, **dadurch gekennzeichnet, dass** der Beginn des Zeitfensters (Wint) mit einem Öffnungsbefehl eines der Schalter synchronisiert ist.

6. System zur Kompensation der Totzeiten (TM) in einer Steuerung der Art IBM (Impulsbreitenmodulation), die an einen Schaltarm (1) angewendet wird, der zwischen zwei Speiseleitungen verbunden ist, wobei der Schaltarm einen ersten Schalter ($T1_1$), einen zweiten Schalter ($T2_1$) und einen Schaltmittelpunkt aufweist, der sich zwischen dem ersten Schalter und dem zweiten Schalter befindet und mit einer elektrischen Last (M) verbunden ist, wobei die IBM-Steuerung für einen Impuls darin besteht, eine Umschaltung des ersten Schalters und eine Umschaltung des zweiten Schalters durchzuführen und eine Totzeit (TM) zwischen die Umschaltung des ersten Schalters und die Umschaltung des zweiten Schalters einzufügen, um eine Ausgangsspannung ($V_{ph}$) an die Last (M) anzulegen, wobei das System **dadurch gekennzeichnet ist, dass** es Folgendes aufweist:

   - einen analogen Integrator (INT), der zur Integration der Ausgangsspannung ($V_{ph}$) während eines bestimmten Zeitfensters (Wint) bestimmt ist, das eine einzige Totzeit (TM) enthält, um eine Kompensationsdauer zu bestimmen,
   - Steuereinrichtungen (200), um die Breite des laufenden Impulses oder diejenige eines folgenden Impulses zu korrigieren, indem die bestimmte Kompensationsdauer angelegt wird.

7. System nach Anspruch 6, **dadurch gekennzeichnet, dass** der Beginn des Zeitfensters (Wint) mit einem Öffnungsbefehl eines der Schalter synchronisiert ist.

8. System nach Anspruch 6 oder 7, **dadurch gekennzeichnet, dass** der analoge Integrator (INT) einen Kondensator aufweist.

9. System nach Anspruch 8, **dadurch gekennzeichnet, dass** die Kompensationsdauer mit Hilfe eines Zyklusende-Augenblicks ($t_2$) bestimmt wird, der bei einer Ladung/Entladung des Kondensators (C3) erfasst wird.

10. System nach Anspruch 9, **dadurch gekennzeichnet, dass** es Steuereinrichtungen (4) des analogen Integrators (INT), die dazu bestimmt sind, die Ladung oder die Entladung des Kondensators (C3) des Integrators (INT) zu aktivieren, und Einrichtungen (5) zur Erfassung des Zyklusende-Augenblicks ($t_2$) aufweist, in dem die Spannung an den Klemmen des Kondensators (C3) nach dem Zeitfenster (Wint) zu ihrem Ruhewert zurückkommt.

**Fig. 1**

**Fig. 2**

**Fig. 3**

**Fig. 4**

***Fig. 5***

***Fig. 6***

**RÉFÉRENCES CITÉES DANS LA DESCRIPTION**

**Documents brevets cités dans la description**

- US 2009278621 A
- US 7286375 B
- US 5450306 A
- EP 0144593 A